(19) Europäisches Patentamt
European Patent Office
Office européen des brevets

(11) **EP 3 759 455 B1**

(12) **FASCICULE DE BREVET EUROPEEN**

(45) Date de publication et mention
de la délivrance du brevet:
**11.08.2021  Bulletin 2021/32**

(51) Int Cl.:
**G01M 15/14** *(2006.01)*     **H03M 1/12** *(2006.01)*

(21) Numéro de dépôt: **19713519.7**

(22) Date de dépôt: **02.04.2019**

(86) Numéro de dépôt international:
**PCT/EP2019/058295**

(87) Numéro de publication internationale:
**WO 2019/197220 (17.10.2019 Gazette 2019/42)**

(54) **MODULE D'ACQUISITION POUR UN SYSTEME DE SURVEILLANCE D'UNE MACHINE TOURNANTE, SYSTEME ET PROCEDE DE SURVEILLANCE**

**ERFASSUNGSMODUL FÜR EINE ROTIERENDEMASCHINE ÜBERWACHUNG, SYSTEM UND VERFAHREN ZU ÜBERWACHUNG**

**ACQUISITION MODULE FOR A ROTATING MACHINE SUPERVISION, SYSTEM AND METHOD OF SUPERVISION**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.04.2018  FR 1853050**

(43) Date de publication de la demande:
**06.01.2021  Bulletin 2021/01**

(73) Titulaire: **SAFRAN**
**75015 Paris (FR)**

(72) Inventeurs:
• **ABBOUD, Dany**
**77550 Moissy-Cramayel (FR)**
• **EL BADAOUI, Mohamed**
**77550 Moissy-Cramayel (FR)**

(74) Mandataire: **Argyma**
**14 Boulevard de Strasbourg**
**31000 Toulouse (FR)**

(56) Documents cités:
EP-A1- 2 507 924        WO-A1-01/23861
WO-A1-2015/131396     JP-A- 2012 079 618

• **M.M Bech ET AL: "Field-oriented control of an induction motor using random pulsewidth modulation", IEEE Transactions on Industry Applications, 1 novembre 2001 (2001-11-01), pages 1777-1785, XP055519719, New York DOI: 10.1109/28.968191 Extrait de l'Internet: URL:https://ieeexplore.ieee.org/ielx5/28/2 0886/00968191.pdf?tp=&arnumber=968191&isn u mber=20886 [extrait le 2001-11-01]**

**Description**

## DOMAINE TECHNIQUE GENERAL ET ART ANTERIEUR

La présente invention concerne le domaine de la surveillance de machines tournantes, en particulier, la surveillance d'un moteur d'aéronef.

Afin de permettre de réaliser une maintenance préventive d'un moteur d'aéronef, il est connu d'utiliser un système de surveillance pour suivre l'état de santé de différents organes du moteur d'aéronef, par exemple, un engrenage, un roulement, une aube mobile, etc.

De manière connue, un système de surveillance comprend un module d'acquisition d'un signal, ci-après module d'acquisition, et un module de traitement configuré pour calculer des estimateurs mathématiques permettant de définir l'état de santé du moteur d'aéronef.

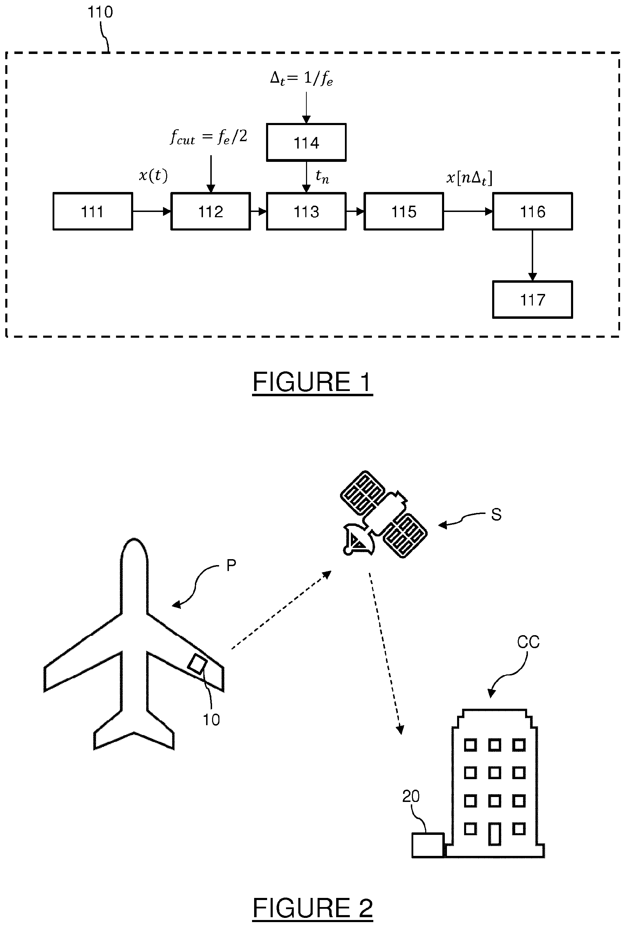

En référence à la figure 1, le module d'acquisition 110 comporte un capteur de mesure 111 configuré pour mesurer une quantité physique, par exemple une accélération, et la convertir en un signal analogique x(t), en particulier, un signal analogique de tension. Le module d'acquisition 110 comporte un échantillonneur-bloqueur 113, connu sous sa désignation anglaise « sample and hold », configuré pour prélever un échantillon du signal analogique $x(t)$ et le maintenir constant pendant une durée de maintien $\Delta_t$ contrôlée par une horloge 114. De manière connue, l'échantillonneur-bloqueur 113 possède une fréquence d'échantillonnage $f_e$ qui est choisie pour respecter le théorème de Shannon, c'est-à-dire, être au moins égale au double de la fréquence maximale contenue dans le signal analogique x(t) à échantillonner. De manière connue, la durée de maintien $\Delta_t$ est fixe et est fonction de la période d'échantillonnage $\Delta_t = 1/f_e$. Aussi, des échantillons sont prélevés à des instants $t_n = n\Delta_t$ où n est un entier naturel.

Toujours en référence à la figure 1, le module d'acquisition 110 comporte en outre un filtre anti-repliement 112 configuré pour rejeter les composantes ayant une fréquence supérieure à la fréquence de Shannon. De manière connue, le filtre anti-repliement 112 possède une fréquence de coupure $f_{cut}$ définie comme la moitié de la fréquence d'échantillonnage $f_e/2$. Le filtre anti-repliement 112 est positionné entre le capteur de mesure 111 et l'échantillonneur-bloqueur 113.

Le module d'acquisition 110 comporte également un convertisseur analogique numérique 115 configuré pour transformer les échantillons du signal analogique en une grandeur numérique $x[n\Delta_t]$ quantifiée sur un nombre limité de bits qui dépend de la précision souhaitée. Comme illustré à la figure 1, le module d'acquisition 110 comporte en outre une mémoire de stockage 116 pour enregistrer les échantillons numériques $x[n\Delta_t]$. Dans cet exemple, le module d'acquisition 110 comporte en outre un module de communication 117, par exemple par voie satellitaire, de manière à transmettre les données de la mémoire 117 à un module de traitement de signal situé au sol dans un centre de contrôle.

De manière connue, le module de traitement de signal se présente sous la forme d'une unité de calcul comprenant un microprocesseur pour réaliser des opérations numériques de traitement du signal sur les échantillons numériques $x[n\Delta_t]$ afin d'en déduire des informations de diagnostic. Les opérations numériques peuvent être diverses et concerner des indicateurs statistiques simples (valeur efficace, Kurtosis, facteur de crête, etc.) mais également des transformées dans le domaine spectral (spectre, analyse d'enveloppe, etc.).

Les transformées dans le domaine spectral sont particulièrement pertinentes dans le domaine de la surveillance d'une machine tournante étant donné qu'une machine tournante génère des signaux dont les statistiques évoluent (quasi-) périodiquement au cours du temps. La périodicité peut se manifester à l'ordre 1 ou à l'ordre 2.

Par exemple, à l'ordre 1, la moyenne du signal est périodique et le spectre est une distribution discrète des harmoniques liée aux fréquences associées à l'élément tournant. Le spectre d'un signal $x[n\Delta_t]$ de longueur $L$ peut être évalué en appliquant la transformée de Fourier discrète (TFD) définie comme :

$$S_x\left[m\Delta_f\right] = TFD_{n \to m}^N\{|x[n\Delta_t]|\} = 1/N \sum_{n=1}^{N} x[n\Delta_t]e^{j2\pi nm/N}$$

Où m = 1,2 ... N and $\Delta_f = \frac{1}{L\Delta_t} = f_e/2$ désigne la résolution fréquentielle qui est proportionnelle à la fréquence d'échantillonnage $f_e$ et inversement proportionnelle au nombre de points. Le facteur 1/ N est optionnel mais signifie que la quantité est relative aux coefficients de Fourier. De manière connue, la transformée ci-dessus peut être calculé par l'algorithme FFT (en anglais « Fast Fourier Transform »). En général, l'amplitude de $X[m\Delta_f]$ sur certaines fréquences révèlent des informations précieuses sur la machine tournante. Un exemple typique est le signal vibratoire émis par un simple axe de rotation ou par un engrenage.

A l'ordre 2, la moyenne du signal est nul, son spectre est continu et donc ne comporte pas d'informations sur la cinématique du système. Par contre, l'enveloppe du signal est périodique et son spectre présente des harmoniques liés à la cinématique de l'organe tournant. Un exemple typique est les vibrations émises par un roulement à bille défectueux. Dans ce cas, le spectre est habituellement incapable de mettre en avant les fréquences de défaut, tandis que le spectre d'enveloppe révèle les fréquences de défauts. Le spectre de l'enveloppe carrée (SEC) est donc un deuxième opérateur précieux de diagnostic, il est défini comme :

$$P_{2x}\left[m\Delta_f\right] = TFD_{n\rightarrow m}^{N}\{|x[n\Delta_t]|^2\}$$

En pratique, dans le domaine de la surveillance d'une machine tournante, il est connu d'utiliser une fréquence d'échantillonnage $f_e$ supérieure à 20 kHz ou supérieure à 50 kHz. Aussi, dans le cas d'une surveillance continue, de très nombreux échantillons numériques $x[n\Delta_t]$ doivent être stockés dans la mémoire 116 et transmis via le module de communication 117. Cela présente de nombreux inconvénients.

Tout d'abord, le coût de transmission des échantillons numériques $x[n\Delta_t]$ par voie satellite est fonction de la quantité de données transmises. De très nombreux échantillons numériques $x[n\Delta_t]$ engendrent ainsi des coûts de transmission importants. Pour éliminer cet inconvénient, une solution serait de transmettre qu'une partie des échantillons numériques $x[n\Delta_t]$ mais cela affecterait la pertinence des estimateurs calculés par le module de traitement.

De même, plus les échantillons numériques $x[n\Delta_t]$ sont nombreux, plus il est nécessaire de prévoir une mémoire 116 dont la dimension est importante, ce qui augmente son coût mais également sa masse, ce qui est contraignant pour une application aéronautique.

Enfin, la consommation électrique de l'échantillonneur-bloqueur 113 dépend de sa fréquence d'échantillonnage $f_e$. Cela est problématique pour la surveillance d'une machine tournante autonome en énergie, par exemple, dans le cas d'éoliennes offshores.

L'invention a donc pour but de remédier à ces inconvénients en proposant un système de surveillance qui permette de réaliser un diagnostic fiable pour une machine tournante avec un nombre réduit d'échantillons.

De manière incidente, on connaît par la demande de brevet WO 2015131396 A1 une méthode de formation d'un spectre à partir d'un signal échantillonné de manière aléatoire. Dans cette application, des signaux particuliers en « dent de scie » sont utilisés afin de réaliser une compression. L'objectif est très éloigné de celui de la présente invention.

De plus, on connaît par la demande de brevet WO 01/23861 A1, un dispositif d'analyse spectrale d'un signal vibratoire d'un roulement ou d'un arbre dans lequel il est proposé d'échantillonner un signal analogique d'un capteur, de le filtrer puis d'analyser son spectre.

## PRESENTATION GENERALE DE L'INVENTION

A cet effet, l'invention concerne un module d'acquisition pour un système de surveillance d'une machine tournante, en particulier d'un moteur d'aéronef, le module d'acquisition comprenant :

- au moins un capteur de mesure d'un signal analogique $x(t)$ de mesure d'une quantité physique d'un organe de la machine tournante,
- au moins un échantillonneur-bloqueur configuré pour prélever un échantillon du signal analogique $x(t)$ à des instants d'échantillonnage $t_n$ et le maintenir constant entre deux instants d'échantillonnage $t_n$,
- au moins une mémoire de stockage des échantillons

Le module d'acquisition est remarquable en ce que l'échantillonneur-bloqueur est configuré pour prélever un échantillon du signal analogique $x(t)$ à des instants d'échantillonnage $t_n$ définis de manière aléatoire, les instants d'échantillonnage $t_n$ étant définis selon la loi suivante

$$t_n = n\Delta_t + \tau_n$$

dans laquelle

$n$ est un entier naturel

$\Delta_t = 1/f_e$ où $f_e$ est la fréquence d'échantillonnage de l'échantillonneur-bloqueur (13)

$\tau_n$ est une variable aléatoire ayant une loi de probabilité uniforme sur $\left[-\frac{\Delta_t}{2}; +\frac{\Delta_t}{2}\right]$

- les échantillons et les instants d'échantillonnage $t_n$ étant stockés dans la mémoire.

Grâce à l'invention, les échantillons ne sont plus prélevés à un même intervalle de temps mais sont prélevés de manière aléatoire, ce qui permet avantageusement de diminuer la fréquence d'échantillonnage par rapport à l'art antérieur et ainsi limiter le nombre d'échantillons à transmettre. Cela est particulièrement avantageux pour une surveillance déportée en continue d'un moteur d'aéronef. L'utilisation d'une telle loi de probabilité est avantageuse car elle admet des propriétés statistiques spectrales optimales, l'erreur quadratique d'estimation étant minimale. Par ailleurs, elle permet d'obtenir des estimateurs non-biaisés et une variance minimale du bruit d'échantillonnage. Grâce aux échantillons et aux instants d'échantillonnage $t_n$ stockés dans la mémoire, le système de surveillance peut former au moins un estimateur pertinent de l'état de santé de la machine tournante.

De préférence, le module d'acquisition comprend au moins un filtre passe-bas analogique ayant une fréquence de coupure $f_{cut}$, le filtre passe-bas analogique étant positionné entre le capteur de mesure et l'échantillonneur-bloqueur. Un tel filtre passe-bas permet de minimiser la variance des estimateurs spectraux calculés par le module de traitement. La précision est augmentée.

De manière préférée, le rapport $f_{cut}/f_e$ est compris entre 3 et 6.

Un échantillonnage aléatoire a l'avantage de ne pas être restreint par la limite de Nyquist comme un échantillonnage uniforme. On peut ainsi utiliser une fréquence de coupure élevée et une fréquence d'échantillonnage qui est basse.

Selon un aspect préféré de l'invention, la fréquence d'échantillonnage $f_e$ est inférieure à 20 kHz, de préférence, comprise entre 100Hz et 1000Hz, de préférence encore, comprise entre 300Hz et 500Hz.

Selon un aspect de l'invention, le module d'acquisition comporte une pluralité de filtres passe-bande analogiques ayant chacun une fréquence de coupure, les filtres passe-bande analogiques étant positionnés entre le capteur de mesure et l'échantillonneur-bloqueur. L'utilisation de filtres passe-bande analogiques permet de définir une pluralité de plage élémentaires de fréquence qui sont chacune échantillonnées de manière indépendante par l'échantillonneur-bloqueur. De manière avantageuse, on peut paramétrer la plage élémentaire de fréquence pour mettre en valeur de manière pertinente un défaut potentiel de l'organe du moteur d'aéronef sur cette plage élémentaire de fréquence. Une plage élémentaire de fréquence permet d'augmenter le rapport signal sur bruit, ce qui facilite la détection d'un dysfonctionnement potentiel.

De préférence, les filtres passe-bande analogiques sont montés en parallèle les uns avec les autres. Ainsi, plusieurs défauts indépendants peuvent être mise en valeur.

De manière préféré, le module d'acquisition comporte un convertisseur analogique numérique configuré pour transformer les échantillons de l'échantillonneur-bloqueur en échantillons numérique $x[n\Delta_t]$.

L'invention concerne également un système de surveillance comprenant un module d'acquisition tel que présenté précédemment et au moins un module de traitement configuré pour calculer au moins un estimateur de santé à partir des échantillons et des instants d'échantillonnage $t_n$ obtenus dudit module d'acquisition.

De manière préférée, le module d'acquisition est configuré pour transmettre les échantillons et les instants d'échantillonnage $t_n$ de manière sans fil au module de traitement, en particulier, par voie satellitaire. La diminution du nombre d'échantillons permet avantageusement de diminuer le coût de transmission.

De préférence, le module de traitement comprend un dispositif de transformation des échantillons selon une transformation de Dirichlet. Une telle transformation permet de former des estimateurs pertinents à partir des échantillons obtenus aléatoirement et des instants d'échantillonnage $t_n$.

L'invention concerne en outre un aéronef comportant un moteur d'aéronef et un module d'acquisition tel que présenté précédemment dont le capteur de mesure est positionné sur un organe du moteur d'aéronef.

L'invention concerne en outre un procédé de surveillance d'une machine tournante, en particulier d'un moteur d'aéronef, par utilisation d'un module d'acquisition tel que présenté précédemment, le procédé comportant :

- une étape de mesure d'un signal analogique $x(t)$ de mesure d'une quantité physique d'un organe de la machine tournante
- une étape d'échantillonnage du signal analogique $x(t)$ à des instants d'échantillonnage $t_n$ définis selon la loi suivante

$$t_n = n\Delta_t + \tau_n$$

dans lequel

n est un entier naturel

$\Delta_t = 1/f_e$ où $f_e$ est la fréquence d'échantillonnage de l'échantillonneur-bloqueur (13)

$\tau_n$ est une variable aléatoire ayant une loi de probabilité uniforme sur $\left[-\frac{\Delta_t}{2}; +\frac{\Delta_t}{2}\right]$.

- une étape d'enregistrement des échantillons et des instants d'échantillonnage $t_n$.

## PRESENTATION DES FIGURES

L'invention sera mieux comprise à la lecture de la description qui va suivre, donnée uniquement à titre d'exemple, et se référant aux dessins annexés sur lesquels :

- la figure 1 est une représentation schématique d'un module d'acquisition selon l'art antérieur,
- la figure 2 est une représentation schématique d'un système de surveillance d'un moteur d'aéronef selon l'invention,
- la figure 3 est une représentation schématique d'un module d'acquisition selon une première forme de réalisation de l'invention,
- la figure 4 est une représentation schématique d'un échantillonnage uniforme selon l'art antérieur,
- la figure 5 est une représentation schématique d'un échantillonnage aléatoire selon l'invention et
- la figure 6 est une représentation schématique d'un module d'acquisition selon une deuxième forme de réalisation de l'invention.

Il faut noter que les figures exposent l'invention de manière détaillée pour mettre en oeuvre l'invention, lesdites figures pouvant bien entendu servir à mieux définir l'invention le cas échéant.

## DESCRIPTION D'UN OU PLUSIEURS MODES DE REALISATION ET DE MISE EN OEUVRE

Il va être dorénavant présenté un système de surveillance selon une forme de réalisation de l'invention pour la surveillance d'un moteur d'aéronef tel qu'un avion ou un hélicoptère. Néanmoins, il va de soi que l'invention s'applique à toute machine tournante, en particulier, une éolienne, un moteur de véhicule terrestre, etc.

En référence à la figure 2, il est représenté un aéronef P en vol et un centre de contrôle CC au sol pour le suivi de l'aéronef P. L'aéronef P comporte plusieurs moteurs dont au moins un moteur est surveillé de manière continue afin de suivre son état de santé. A cet effet, le système de surveillance comporte un module d'acquisition 10 relié à un ou plusieurs moteurs de l'aéronef et un module de traitement 20 situé au sol dans le centre de contrôle CC. Dans cet exemple, le module d'acquisition 10 peut communiquer avec le module de traitement 20 par une liaison satellitaire S.

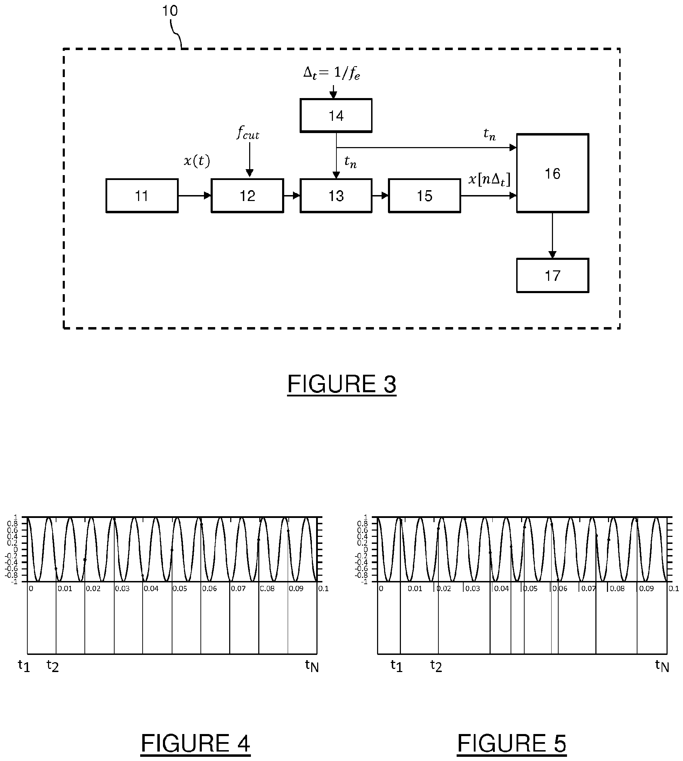

Une première forme de réalisation d'un module d'acquisition 10 est présenté à la figure 3. Le module d'acquisition 10 comporte un capteur de mesure 11 d'un signal analogique représentatif d'une quantité physique d'un organe du moteur d'aéronef.

Le module d'acquisition 10 comporte un capteur de mesure 11 configuré pour mesurer une quantité physique, par exemple une accélération, et la convertir en un signal analogique $x(t)$, notamment, un signal de tension. Le capteur de mesure 11 est placé sur un organe du moteur d'aéronef, par exemple, au voisinage d'une soufflante, d'un roulement, etc. Un tel capteur de mesure 11 est connu de l'homme du métier et peu présenter des formes diverses en fonction de la quantité physique à mesurer.

En outre, le module d'acquisition 10 comporte un échantillonneur-bloqueur 13, connu sous sa désignation anglaise « sample and hold », configuré pour prélever un échantillon du signal analogique $x(t)$ à des instants d'échantillonnage $t_n$ et le maintenir constant entre deux instants d'échantillonnage $t_n$. L'échantillonneur-bloqueur 13 possède une fréquence d'échantillonnage $f_e$ qui est choisie pour respecter le théorème de Shannon, c'est-à-dire, être au moins égale au double de la fréquence maximale contenue dans le signal analogique $x(t)$ à échantillonner.

Selon l'invention, l'échantillonneur-bloqueur 13 est configuré pour prélever un échantillon du signal analogique de tension $x(t)$ à des instants d'échantillonnage $t_n$ définis selon la loi suivante

$$t_n = n\Delta_t + \tau_n$$

dans lequel

$n$ est un entier naturel

$\Delta_t = 1/f_e$ où $f_e$ est la fréquence d'échantillonnage de l'échantillonneur-bloqueur 13

$\tau_n$ est une variable aléatoire ayant une loi de probabilité uniforme sur $[-\frac{\Delta_t}{2}; +\frac{\Delta_t}{2}]$.

Dans cet exemple, en référence à la figure 3, le module d'acquisition comporte une horloge 14 pour déterminer les instants d'échantillonnage $t_n$ comme indiqué ci-dessus.

Ainsi, grâce à l'invention, pour la surveillance d'un moteur d'aéronef, les instants d'échantillonnage $t_n$ sont déterminés de manière aléatoire et non plus de manière uniforme comme dans l'art antérieur. Autrement dit, contrairement à l'art antérieur dans lequel le temps entre deux instants d'échantillonnage $t_n$ était fixe (Figure 4), le temps entre deux instants d'échantillonnage $t_n$ est dorénavant variable (Figure 5).

L'utilisation d'une loi de probabilité uniforme sur $\left[-\frac{\Delta_t}{2}; +\frac{\Delta_t}{2}\right]$ pour la variable aléatoire $\tau_n$ est avantageuse car elle admet des propriétés statistiques spectrales optimales, l'erreur quadratique d'estimation étant minimale. Par ailleurs, elle permet d'obtenir des estimateurs non-biaisés et une variance minimale du bruit d'échantillonnage. Après avoir réalisé des calculs théoriques, il apparait que la loi statistique optimale pour échantillonner un signal avec un nombre N d'échantillons aléatoirement acquis sur une durée d'acquisition T est la loi statistique uniforme centrée sur $nT/M = n\Delta_t$ et de largeur $T/M = \Delta_t$.

De même, les calculs théoriques ont montré que la résolution fréquentielle dans le cadre d'un échantillonnage aléatoire est égale à l'inverse de la durée d'acquisition T. Pour rappel, la durée d'acquisition T est égale à la résolution fréquentielle pour un échantillonnage uniforme. Cette propriété est particulièrement avantageuse pour analyser des signaux mécaniques d'une machine tournante car la résolution fréquentielle doit être choisie plus petite que l'espacement entre 2 harmoniques fréquentielles afin de pouvoir les identifier.

Contrairement à l'art antérieur, une fréquence d'échantillonnage $f_e$ plus faible que dans l'art antérieur peut être choisie tout au long de la durée d'acquisition T sans limiter la bande passante du spectre du signal, c'est à dire, sans réduire la fréquence de Nyquist. Une telle fréquence d'échantillonnage $f_e$ est avantageuse étant donné qu'elle permet, d'une part, de limiter le nombre d'échantillons et donc le nombre de données à transmettre au module de traitement 20 et, d'autre part, d'obtenir une résolution fréquentielle optimale, ce qui est avantageux lors du traitement des échantillons comme cela sera présenté par la suite pour obtenir des estimateurs spectraux pertinents.

Pour permettre une estimation qualitative, le nombre d'échantillons doit néanmoins rester suffisant afin d'obtenir une variance du bruit d'échantillonnage de faible valeur, la variance du bruit d'échantillonnage étant inversement proportionnelle aux nombres d'échantillons. Aussi, le nombre d'échantillons peut être réduit mais dans la limite de la précision souhaitée.

Contrairement à l'art antérieur, les instants d'échantillonnage $t_n$ sont requis par le module de traitement 20 afin de calculer des estimateurs et doivent donc être sauvegardés comme cela sera présenté par la suite. La conservation des instants d'échantillonnage $t_n$ n'est pas pénalisante étant donné que le nombre d'échantillons est considérablement réduit par comparaison à l'art antérieur.

Dans cet exemple, le module d'acquisition 10 comporte en outre un filtre passe-bas analogique 12 ayant une fréquence de coupure $f_{cut}$. Le filtre passe-bas analogique 12 est positionné entre le capteur de mesure 11 et l'échantillonneur-bloqueur 13 comme illustré à la figure 3.

Bien qu'ayant une structure analogue à un filtre anti-repliement selon l'art antérieur, le filtre passe-bas analogique 12 selon l'invention permet de rejeter les composantes du signal analogique $x(t)$ au-delà de la fréquence de coupure $f_{cut}$ afin de minimiser la variance des estimateurs spectraux calculés par le module de traitement 20. La fréquence de coupure $f_{cut}$ définie donc la plage de fréquence utile à explorer. Aussi, la fréquence de coupure $f_{cut}$ est choisie pour être supérieure à la valeur maximale de la plage spectrale souhaitée. De manière préféré, le rapport $f_{cut}/f_e$ est compris entre 3 et 6.

Un échantillonnage aléatoire a l'avantage de ne pas être restreint par la limite de Nyquist comme un échantillonnage uniforme. Néanmoins, l'échantillonnage aléatoire a une incidence sur le bruit aléatoire présent dans le spectre. Les calculs théoriques ont montré que la variance du bruit aléatoire est proportionnelle à l'énergie du signal mesuré. Pour cette raison, il est avantageux de filtrer, par un filtre passe-bas analogique 12, les fréquences indésirables qui sont supérieures à la fréquence de coupure $f_{cut}$.

Le module d'acquisition 10 comporte également un convertisseur analogique numérique 15 configuré pour transformer les échantillons maintenus constants par l'échantillonneur-bloqueur 13 en échantillons numérique $x[n\Delta_t]$ quantifiés sur un nombre limité de bits qui dépend de la précision souhaitée. Un tel convertisseur analogique numérique 15 est analogue à l'art antérieur et connu de l'homme du métier.

Comme illustré à la figure 3, le module d'acquisition 10 comporte en outre une mémoire de stockage 16 pour stocker les échantillons numériques $x[n\Delta_t]$ ainsi que les instants d'échantillonnage $t_n$.

Dans cet exemple, le module d'acquisition 10 comporte en outre un module de communication 17, par exemple par voie satellitaire, de manière à transmettre les données de la mémoire 16 au module de traitement 20 situé au sol dans le centre de contrôle CC.

Contrairement à l'art antérieur, les instants d'échantillonnage $t_n$ doivent être stockés dans la mémoire 16 afin de permettre au module de traitement 20 de calculer des estimateurs de l'état de santé du moteur d'aéronef. Néanmoins, comme le nombre d'échantillons numériques $x[n\Delta_t]$ est grandement diminué par rapport à l'art antérieur, la quantité de données devant être transmise entre le module d'acquisition 10 et le module de traitement 20 est plus faible que dans l'art antérieur. Cela diminue avantageusement le coût de transmission et réduit le dimensionnement de la mémoire 16.

Grâce à l'invention, on obtient un module d'acquisition 10 qui permet de prélever un nombre restreint d'échantillons numériques $x[n\Delta_t]$ et d'instants d'échantillonnage $t_n$ tout en permettant le calcul d'estimateurs pertinents par le module de traitement 20 comme cela va être maintenant présenté.

Le module de traitement 20 comporte une unité de calcul, en particulier un microprocesseur, pour réaliser des opérations mathématiques à partir des échantillons numériques $x[n\Delta_t]$ obtenus aléatoirement ainsi que des instants d'échantillonnage $t_n$.

De manière préférée, le module de traitement 20 met en oeuvre une transformée de Dirichlet définie de manière suivante :

$$X(f) = DIR_{n \to m}^{N}\{x[n\Delta_t]\} = \frac{1}{N}\sum_{n=1}^{N} x[t_n]e^{-j2\pi f t_n}.$$

Où $f$ désigne la variable continue de fréquence variant théoriquement jusqu'à l'infini

N désigne le nombre d'échantillons

Afin de pouvoir appliquer la transformée de Dirichlet de manière optimale, la connaissance de la résolution fréquentielle $\Delta_f$ est souhaitée. Pour rappel, la résolution fréquentielle $\Delta_f$ est égale à l'inverse de la durée d'acquisition T : $\Delta_f$ = 1/$T$.

En pratique, il n'est pas utile de calculer les fréquences au-delà de la fréquence de coupure $f_{cut}$ du filtre passe-bas analogique 12 étant donné que les coefficients de Fourrier sont pratiquement nuls. Aussi, afin de réduire le coût de calcul, m doit prendre les valeurs suivantes : $m$ = 0,1, ... $M$-1 avec $M$ = $f_{cut}/\Delta_f$. Contrairement à la TFD, l'index maximal de fréquence peut dépasser le nombre des échantillons : $M > N$, l'échantillonnage aléatoire n'étant pas limité par le théorème de Shannon.

Un exemple de calcul d'estimateurs est présenté par la suite.

Soit $\underline{x}$ = $[x[t_1], x[t_2] ...x[t_N]]^T$ ($^T$ désigne l'opérateur transpose) un vecteur de taille $N$ échantillonné aléatoirement aux instants $t_1 ... t_N$ et $\underline{X}$ = $[X[\Delta f], X[2. \Delta f] ... X[M.\Delta f]]^T$ son spectre estimé par la transformée de Dirichlet, la relation entre x et X s'exprime sous forme matricielle comme :

$$\underline{X} = \mathbf{\Phi}.\underline{x}$$

où $\Phi$ désigne la matrice de taille ($M, N$) de la transformée de Dirichlet tel que :

$$\mathbf{\Phi}(m,n) = e^{j2\pi(m-1)\Delta f t_n}, 1 < m \le M \ et \ 1 < n \le N$$

De même le spectre de l'enveloppe carrée (SEC) pourrait être également exprimé comme :

$$\underline{P} = \mathbf{\Phi}.\underline{x}^2$$

où

$$\underline{x}^2 = \left[x^2[t_1], x^2[t_2] ... x^2[t_N]\right]^T.$$

De tels estimateurs sont avantageux car ils permettent de révéler de manière pertinente et fiable des défauts d'un moteur d'aéronef et, plus généralement, d'une machine tournante.

Un exemple de mise en oeuvre d'un procédé de surveillance d'un moteur d'aéronef va être dorénavant présenté au moyen du système de surveillance présenté précédemment. En référence à la figure 2, le système de surveillance comporte un module d'acquisition 10 relié à un ou plusieurs moteurs de l'aéronef P et un module de traitement 20 situé au sol dans le centre de contrôle CC. Dans cet exemple, le module d'acquisition 10 communique avec le module de traitement 20 par une liaison satellitaire S.

Le procédé de surveillance comporte une étape de mesure, par le capteur de mesure 11 du module d'acquisition 10, d'un signal analogique $x(t)$ représentatif d'une quantité physique d'un organe de la machine tournante, par exemple, une accélération.

Puis, le procédé comporte une étape de filtrage, par le filtre passe-bas 12, des fréquences supérieures à la fréquence de coupure $f_{cut}$ dudit filtre passe-bas 12. Ensuite, le procédé comporte une étape d'échantillonnage du signal analogique $x(t)$ à des instants d'échantillonnage $t_n$ définis de manière aléatoire selon la loi définie précédemment. Dans cet exemple, la fréquence d'échantillonnage $f_e$ est inférieure à 20 kHz, de préférence, comprise entre 100Hz et 1000Hz, de préférence encore, comprise entre 300Hz et 500Hz de manière à limiter le nombre d'échantillons.

Puis, le procédé de surveillance comporte une étape de conversion numérique des échantillons par le convertisseur analogique numérique 15 et une étape d'enregistrement des échantillons numériques $x[n\Delta_t]$ avec les instants d'échantillonnage $t_n$ dans la mémoire 16.

De manière avantageuse, la quantité de données enregistrée dans la mémoire 16 est limitée par comparaison à l'art antérieur, ce qui permet une transmission par le module de communication 17 moins onéreuse.

Les données de la mémoire 16, c'est-à-dire les échantillons numériques $x[n\Delta_t]$ ainsi que les instants d'échantillonnage $t_n$ sont reçus par le module de traitement 20 qui peut ainsi calculer des estimateurs pertinents de manière mathématique. De manière avantageuse, le module de traitement 20 met en oeuvre une transformée par Dirichlet à partir des échantillons numériques $x[n\Delta_t]$ et des instants d'échantillonnage $t_n$ afin de former des indicateurs pertinents, notamment, le spectre de l'enveloppe carrée (SEC).

Ainsi, grâce à l'invention, des estimateurs pertinents peuvent être obtenus avec une quantité moindre de données tout en conservant les données pertinentes caractéristiques des machines tournantes et, en particulier, des moteurs d'aéronef.

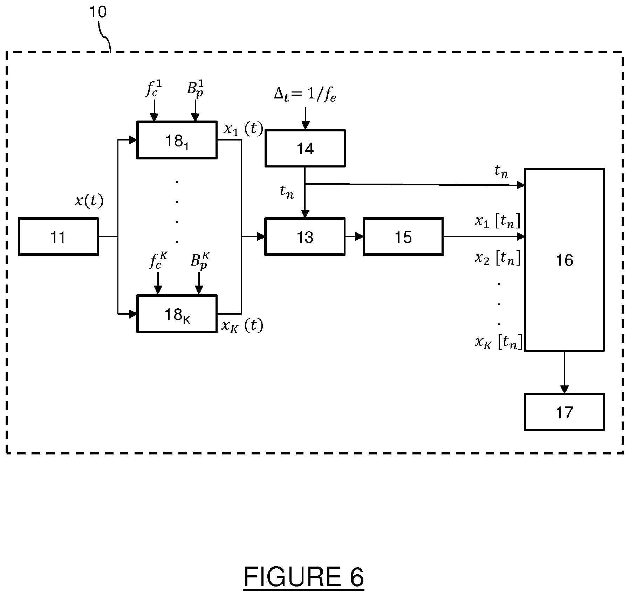

Une deuxième forme de réalisation d'un module d'acquisition 10 est représentée en référence à la figure 6. Par souci de concision et de clarté, seules les différences structurelles et fonctionnelles avec la première forme de réalisation de la figure 3 vont être présentées.

Dans cette forme de réalisation, comme illustré à la figure 6, le filtre passe-bas 12 est remplacé par une pluralité de filtres passe-bande analogiques $18_1$, $18_k$ qui sont montés en parallèle les uns avec les autres.

Les filtres passe-bande $18_1$, $18_K$ permettent de découper la plage de fréquence en une pluralité de plages élémentaires de fréquence qui sont chacune échantillonnées de manière indépendante par l'échantillonneur-bloqueur 13. Chaque plage élémentaire de fréquence est définie par sa fréquence centrale $\left(f_c^K\right)$ et sa bande passante $\left(B_p^K\right)$ comme illustré à la figure 6. L'utilisation de filtres passe-bande 181, 18K est intéressante dans le cas d'un engrenage planétaire ou droit dans lequel la signature des défauts apparait autour de la fréquence d'engrènement qui est connu. Dans ce cas, un filtre passe-bande analogique peut être appliqué avec une fréquence centrale $f_c$ égale à la fréquence d'engrènement $f_{eng}$ et une largeur de bande $B_p$ égale à $f_{eng}/2$.

De manière avantageuse, on peut paramétrer chaque plage élémentaire de fréquence pour mettre en valeur de manière pertinente un défaut potentiel de l'organe du moteur d'aéronef sur cette plage élémentaire de fréquence. Une plage élémentaire de fréquence permet d'augmenter le rapport signal sur bruit, ce qui facilite la détection d'un dysfonctionnement potentiel.

## Revendications

1. Module d'acquisition (10) pour un système de surveillance d'une machine tournante, en particulier d'un moteur d'aéronef, le module d'acquisition (10) comprenant :

   - au moins un capteur de mesure (11) d'un signal analogique $x(t)$ de mesure d'une quantité physique d'un organe de la machine tournante,
   - au moins un échantillonneur-bloqueur (13) configuré pour prélever un échantillon du signal analogique $x(t)$ à des instants d'échantillonnage $t_n$ et le maintenir constant entre deux instants d'échantillonnage $t_n$,
   - au moins une mémoire (16) de stockage des échantillons **module d'acquisition caractérisé par le fait que** l'échantillonneur-bloqueur (13) est configuré pour prélever un échantillon du signal analogique $x(t)$ à des instants d'échantillonnage $t_n$ définis de manière aléatoire, les instants d'échantillonnage $t_n$ étant définis selon la loi suivante

$$t_n = n\Delta_t + \tau_n$$

   dans laquelle

   n est un entier naturel
   $\Delta_t = 1/f_e$ où $f_e$ est la fréquence d'échantillonnage de l'échantillonneur-bloqueur (13)

$\tau_n$ est une variable aléatoire ayant une loi de probabilité uniforme sur $[-\frac{\Delta_t}{2}; +\frac{\Delta_t}{2}]$

- les échantillons et les instants d'échantillonnage $t_n$ étant stockés dans la mémoire (16).

2. Module d'acquisition selon la revendication 1, comprenant au moins un filtre passe-bas analogique (12) ayant une fréquence de coupure $f_{cut}$, le filtre passe-bas analogique (12) étant positionné entre le capteur de mesure (11) et l'échantillonneur-bloqueur (13).

3. Module d'acquisition selon l'une des revendications 1 à 2, dans lequel la fréquence d'échantillonnage $f_e$ est inférieure à 20 kHz, de préférence, comprise entre 100Hz et 1000Hz, de préférence encore, comprise entre 300Hz et 500Hz.

4. Module d'acquisition selon l'une des revendications 1 à 3, comprenant une pluralité de filtres passe-bande analogiques (18$_1$, 18$_K$) ayant chacun une fréquence de coupure (f$_{cut1}$, f$_{cutK}$), les filtres passe-bande analogiques (18$_1$, 18$_K$) étant positionnés entre le capteur de mesure (11) et l'échantillonneur-bloqueur (13).

5. Module d'acquisition selon la revendication 4, dans lequel les filtres passe-bande analogiques (18$_1$, 18$_K$) sont montés en parallèle les uns avec les autres.

6. Module d'acquisition selon l'une des revendications 1 à 5, comprenant un convertisseur analogique numérique (15) configuré pour transformer les échantillons de l'échantillonneur-bloqueur (13) en échantillons numérique $x[n\Delta_t]$.

7. Système de surveillance comprenant un module d'acquisition (10) selon l'une des revendications 1 à 6 et au moins un module de traitement (20) configuré pour calculer au moins un estimateur de santé à partir des échantillons et des instants d'échantillonnage $t_n$ obtenus dudit module d'acquisition (10).

8. Système de surveillance selon la revendication 7, dans lequel le module de traitement (20) comprend un dispositif de transformation des échantillons selon une transformation de Dirichlet.

9. Aéronef comportant un moteur d'aéronef et un module d'acquisition (10) selon l'une des revendications 1 à 6 dont le capteur de mesure (11) est positionné sur un organe du moteur d'aéronef.

10. Procédé de surveillance d'une machine tournante, en particulier d'un moteur d'aéronef, par utilisation d'un module d'acquisition (10) selon l'une des revendications 1 à 6, le procédé comportant :

- une étape de mesure d'un signal analogique $x(t)$ de mesure d'une quantité physique d'un organe de la machine tournante
- une étape d'échantillonnage du signal analogique $x(t)$ à des instants d'échantillonnage $t_n$ définis selon la loi suivante

$$t_n = n\Delta_t + \tau_n$$

dans lequel

$n$ est un entier naturel
$\Delta_t = 1/f_e$ où $f_e$ est la fréquence d'échantillonnage de l'échantillonneur-bloqueur (13)
$\tau_n$ est une variable aléatoire ayant une loi de probabilité uniforme sur $[-\frac{\Delta_t}{2}; +\frac{\Delta_t}{2}]$.

- une étape d'enregistrement des échantillons et des instants d'échantillonnage $t_n$.

**Patentansprüche**

1. Erfassungsmodul (10) für ein Überwachungssystem einer drehenden Maschine, insbesondere eines Fluggerätemotors, wobei das Erfassungsmodul (10) umfasst:

- mindestens einen Messsensor (11) eines analogen Messsignals $x(t)$ einer physikalischen Größe eines Organs der drehenden Maschine,
- mindestens eine Sample-and-Hold-Schaltung (13), die ausgelegt ist, um ein Sample des analogen Signals $x(t)$ zu Samplingzeitpunkten $t_n$ zu entnehmen und es zwischen zwei Samplingzeitpunkten $t_n$ konstant zu halten,
- mindestens einen Speicher (16) der Samples,

wobei das Erfassungsmodul **dadurch gekennzeichnet ist, dass** die Sample-and-Hold-Schaltung (13) ausgelegt ist, um ein Sample des analogen Signals $x(t)$ zu zufallsbestimmten Samplingzeitpunkten $t_n$ zu entnehmen, wobei die Samplingzeitpunkte $t_n$ gemäß dem folgenden Gesetz bestimmt sind

$$t_n = n\Delta_t + T_n$$

wobei

$n$ eine natürliche Ganzzahl ist

$\Delta_t = 1/f_e$, wobei $f_e$ die Samplingfrequenz der Sample-and-Hold-Schaltung (13) ist

$T_n$ eine Zufallsvariable mit einer stetigen Wahrscheinlichkeitsverteilung über $\left[-\frac{\Delta_t}{2}; +\frac{\Delta_t}{2}\right]$ ist

- die Samples und die Samplingzeitpunkte $t_n$ im Speicher (16) gespeichert sind.

2. Erfassungsmodul nach Anspruch 1, umfassend mindestens einen analogen Tiefpassfilter (12) mit einer Grenzfrequenz $f_{cut}$, wobei der analoge Tiefpassfilter (12) zwischen dem Messsensor (11) und der Sample-and-Hold-Schaltung (13) positioniert ist.

3. Erfassungsmodul nach einem der Ansprüche 1 bis 2, wobei die Samplingfrequenz $f_e$ niedriger als 20 kHz ist, vorzugsweise zwischen 100 Hz und 1000 Hz liegt, ebenfalls vorzugsweise zwischen 300 Hz und 500 Hz liegt.

4. Erfassungsmodul nach einem der Ansprüche 1 bis 3, umfassend eine Vielzahl analoger Bandpassfilter ($18_1$, $18_K$) mit jeweils einer Grenzfrequenz ($f_{cut1}$, $f_{cutK}$), wobei die analogen Bandpassfilter ($18_1$, 18K) zwischen dem Messsensor (11) und der Sample-and-Hold-Schaltung (13) positioniert sind.

5. Erfassungsmodul nach Anspruch 4, wobei die analogen Bandpassfilter ($18_1$, $18_K$) parallel zueinander angebracht sind.

6. Erfassungsmodul nach einem der Ansprüche 1 bis 5, umfassend einen Digital-Analog-Wandler (15), der ausgelegt ist, um die Samples der Sample-and-Hold-Schaltung (13) in digitale Samples $x[n\Delta_t]$ umzuwandeln.

7. Überwachungssystem, umfassend ein Erfassungsmodul (10) nach einem der Ansprüche 1 bis 6 und mindestens ein Verarbeitungsmodul (20), das ausgelegt ist, um mindestens einen Gesundheitsabschätzer auf der Basis der von dem Erfassungsmodul (10) erhaltenen Samples und der Samplingzeitpunkte $t_n$ zu berechnen.

8. Überwachungssystem nach Anspruch 7, wobei das Verarbeitungsmodul (20) eine Transformationsvorrichtung der Samples gemäß einer Dirichlet-Transformation umfasst.

9. Fluggerät, aufweisend einen Fluggerätemotor und ein Erfassungsmodul (10) nach einem der Ansprüche 1 bis 6, dessen Messsensor (11) auf einem Organ des Fluggerätemotors positioniert ist.

10. Verfahren zur Überwachung einer drehenden Maschine, insbesondere eines Fluggerätemotors, durch Verwendung eines Erfassungsmoduls (10) nach einem der Ansprüche 1 bis 6, wobei das Verfahren aufweist:

- einen Messschritt eines analogen Messsignals $x(t)$ einer physikalischen Größe eines Organs der drehenden Maschine
- einen Samplingschritt des analogen Signals $x(t)$ zu Samplingzeitpunkten $t_n$, definiert gemäß dem folgenden Gesetz

$$t_n = n\Delta_t + \tau_n$$

wobei

$n$ eine natürliche Ganzzahl ist

$\Delta_t$ = 1/$f_e$, wobei $f_e$ die Samplingfrequenz der Sample-and-Hold-Schaltung (13) ist

$T_n$ eine Zufallsvariable mit einer stetigen Wahrscheinlichkeitsverteilung über $[-\frac{\Delta_t}{2}; +\frac{\Delta_t}{2}]$ ist

- einen Speicherschritt der Samples und der Samplingzeitpunkte $t_n$.

**Claims**

1. An acquisition module (10) for a system for monitoring a rotating machine, in particular an aircraft engine, the acquisition module (10) comprising:

   - at least one sensor (11) for measuring an analog signal $x(t)$ for measuring a physical quantity of a member of the rotating machine,
   - at least one sample-and-hold device (13) configured to take a sample of the analog signal $x(t)$ at sampling time instants $t_n$ and keep it constant between two sampling time instants $t_n$,
   - at least one memory (16) for storing the samples,
   which acquisition module is **characterised in that** the sample-and-hold device (13) is configured to take a sample of the analog signal $x(t)$ at sampling time instants $t_n$ randomly defined, the sampling time instants $t_n$ being defined according to the following law

   $$t_n = n\Delta_t + \tau_n$$

   in which

   n is a natural integer

   $\Delta_t$ = 1/$f_e$ where $f_e$ is the sampling frequency of the sample-and-hold device (13)

   $\tau_n$ is a random variable having a uniform probability distribution on $[-\frac{\Delta_t}{2}; +\frac{\Delta_t}{2}]$

   - the samples and sampling time instants $t_n$ being stored in the memory (16).

2. The acquisition module according to claim 1, comprising at least one analog low-pass filter (12) having a cut-off frequency $f_{cut}$, the analog low-pass filter (12) being positioned between the measuring sensor (11) and the sample-and-hold device (13).

3. The acquisition module according to one of claims 1 to 2, wherein the sampling frequency $f_e$ is lower than 20kHz, preferably, of between 100 Hz and 1000Hz, more preferably, of between 300Hz and 500Hz.

4. The acquisition module according to one of claims 1 to 3, comprising a plurality of analog band-pass filters ($18_1$, $18_K$) each having a cut-off frequency ($f_{cut1}$, $f_{cutK}$), the analog band-pass filters ($18_1$, $18_K$) being positioned between the measuring sensor (11) and the sample-and-hold device (13).

5. The acquisition module according to claim 4, wherein the analog band-pass filters ($18_1$, $18_K$) are connected in parallel to each other.

6. The acquisition module according to one of claims 1 to 5, comprising an analog-digital converter (15) configured to transform the samples of the sample-and-hold device (13) into digital samples $x[n\Delta_t]$.

7. A monitoring system comprising an acquisition module (10) according to one of claims 1 to 6 and at least one processing module (20) configured to calculate at least one health estimator from the samples and sampling time instants $t_n$ obtained from said acquisition module (10).

8. The monitoring system according to claim 7, wherein the processing module (20) comprises a module for transforming the samples according to a Dirichlet transform.

9. An aircraft comprising an aircraft engine and an acquisition module (10) according to one of claims 1 to 6 the measuring sensor (11) of which is positioned on a member of the aircraft engine.

10. A method for monitoring a rotating machine, in particular an aircraft engine, by using an acquisition module (10) according to one of claims 1 to 6, the method comprising:

- a step of measuring an analog signal $x(t)$ for measuring a physical quantity of a member of the rotating machine,
- a step of sampling the analog signal $x(t)$ at sampling time instants $t_n$ defined according to the following law

$$t_n = n\Delta_t + \tau_n$$

wherein

n is a natural integer
$\Delta_t = 1/f_e$ where $f_e$ is the sampling frequency of the sample-and-hold device (13)

$\tau_n$ is a random variable having a uniform probability distribution on $[-\frac{\Delta_t}{2}; +\frac{\Delta_t}{2}]$

- a step of recording the samples and sampling time instants $t_n$.

## FIGURE 1

## FIGURE 2

10

$$\Delta_t = 1/f_e$$

14

$f_{cut}$

$x(t)$

$t_n$

$t_n$

11 → 12 → 13 → 15 → $x[n\Delta_t]$ → 16

17

## FIGURE 3

$t_1$ $t_2$ $t_N$

$t_1$ $t_2$ $t_N$

## FIGURE 4     FIGURE 5

FIGURE 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- WO 2015131396 A1
- WO 0123861 A1